Europäisches Patentamt

European Patent Office

Office européen des brevets

(11) Veröffentlichungsnummer: **0 171 699**
**B1**

(12) **EUROPÄISCHE PATENTSCHRIFT**

(45) Veröffentlichungstag der Patentschrift:
**16.09.87**

(21) Anmeldenummer: **85109531.5**

(22) Anmeldetag: **29.07.85**

(51) Int. Cl.⁴: **C 23 D 5/00, C 03 C 3/064,**
**C 03 C 4/16, C 03 C 8/02,**
**C 23 D 5/04, H 01 B 3/08,**
**H 05 K 1/05, H 05 B 3/02**

(54) **Beschichtung für metallische Substrate.**

(30) Priorität: **11.08.84 DE 3429666**
**20.12.84 DE 3446554**

(43) Veröffentlichungstag der Anmeldung:
**·19.02.86 Patentblatt 86/8**

(45) Bekanntmachung des Hinweises auf die Patenterteilung:
**16.09.87 Patentblatt 87/38**

(84) Benannte Vertragsstaaten:
**BE DE FR GB IT NL**

(56) Entgegenhaltungen:
**US - A - 3 598 620**

(73) Patentinhaber: **BAYER AG, Konzernverwaltung RP**
**Patentabteilung, D-5090 Leverkusen 1 Bayerwerk (DE)**

(72) Erfinder: **Schittenhelm, Hans-Joachim, Dr.,**
**Walter-Flex-Strasse 6, D-5090 Leverkusen (DE)**
Erfinder: **Joseph, Werner, Dr.,**
**Ludwig-Aschoff-Strasse 20, D-5000 Köln 80 (DE)**
Erfinder: **Krist, Otto, Grosshurdener Berg 8,**
**D-5063 Overath (DE)**

ACTORUM AG

## Beschreibung

Die vorliegende Erfindung betrifft elektrisch isolierende Beschichtungen für metallische Substrate, die insbesondere für gedruckte Leiter- und Widerstandsbahnen als Basismaterial für die Elektro- und Elektronikindustrie dienen.

Silikatisch beschichtete Stahlsubstrate sind als Leiterplatten für gedruckte Schaltungen solchen aus organischer Polymeren, Aluminiumoxid oder Sinterkeramik hinsichtlich ihrer Temperaturbeständigkeit, mechanischen Stabilität und Wärmeleitvermögen überlegen. Darüber hinaus bieten sie bei grossflächigen Formaten wirtschaftliche Vorteile. Derartige beschichtete Stahlsubstrate sind z.B. aus — Chemie — Anlagen und Verfahren CAV 1981, Sept. S. 60; Markt und Technik, Wochenzeitung für Elektronik 24, 1979; Proceedings of the Porcelain Enamel Institute, Vol. 42 (1980), S. 160-165 bekannt.

Voraussetzung für den Einsatz silikatischer Schichten auf metallischen Trägerstoffen sind ausreichende Haftung, glatte gleichmässige Oberflächen, gute Kantenabdeckung sowie besondere dielektrische Eigenschaften wie z.B. hoher elektrischer Widerstand und Durchschlagspannung.

In der Praxis haben sich borosilikatische Gläser mit geringen Alkaligehalten bewährt. Diese werden analog Emailfritten auf das vorbehandelte Stahlsubstrat in Schlickerform oder als Pulver aufgebracht und bei Temperaturen von 800 bis 850°C aufgeschmolzen (vgl. z.B. DE-PS 2015072).

Es wurde auch vorgeschlagen, Bariumborat als elektrisch isolierende Schicht aufzubringen. Dies hat allerdings den Nachteil, dass dabei keine glatten Oberflächen erzielt werden (vgl. z.B. US-PS 4 355 115).

Der elektrische Widerstand borosilikatischer Gläser nimmt bekanntlich mit steigender Temperatur ab. Der spezifische Durchgangswiderstand einer auf Metallsubstrate in üblicher Weise aufgebrachten Schicht sinkt bereits bei einer Temperaturerhöhung auf 200°C um mehrere Grössenordnungen ab. Neuerdings besteht der Wunsch nach elektrisch isolierenden Beschichtungen metallischer Werkstücke, deren Widerstand auch bei höheren Temperaturen erhalten bleibt. Es war daher Aufgabe der vorliegenden Erfindung, Beschichtungen für metallische Substrate bereitzustellen, die diese Forderungen erfüllen.

Gegenstand der vorliegenden Erfindung sind nun mit elektrisch isolierenden Schichten mit geringer Temperaturabhängigkeit des Widerstands versehene Metallsubstrate, welche dadurch gekennzeichnet sind, dass die isolierende Schicht im wesentlichen aus einem aufgeschmolzenen Material besteht, dass 43-47% $B_2O_3$, 29-33% CaO, 10-15% $SiO_2$, 7-10% $Al_2O_3$ und 1-2% MgO enthält.

Die Beschichtung wird in an sich bekannter Weise in Form eines Schlickers oder eines Pulvers aufgebracht. Beispielsweise kann dies nach einem Verfahren wie es in der DE-PS 2 015 072 beschrieben ist, erfolgen. Die Einbrenntemperaturen sollen dabei zwischen 800°C und 850°C liegen.

Als Substrate können in üblicher Weise entfettete, gebeizte und mit einer Nickelauflage von ca. 0,5-1,5 $g/m^3$ versehene Stahlbleche eingesetzt werden.

Als Beschichtungsmaterial eignet sich ein aus einem Gemisch von Borsäure, Calciumcarbonat, Magnesiumcarbonat, Quarz und alkalifreiem Tonmineral erschmolzenes Produkt. Besonders einfach ist es, von einer Mischung der Mineralien Colemanit und Ton auszugehen.

Überraschenderweise wurde gefunden, dass ein derartiges auf Stahlblech aufgeschmolzenes Material nur eine sehr geringe Temperaturabhängigkeit des spezifischen Durchgangswiderstands aufweist.

Der Durchgangswiderstand der so beschichteten Substrate lässt sich in Abhängigkeit von der Temperatur unschwer bestimmen nach DIN 53 482/VDE 0303/Teil 3, IEC-Publ. 93.

Die Messung erfolgt kontinuierlich an 10 × 10 cm Prüflingen. Zur Messung wurden Haftelektroden mit einer Messfläche von 16 $cm^2$ verwendet. Als Spannung dienten sowohl 100 als auch 500 Volt.

Der Unterschied der erfindungsgemässen Boroxid- und Calziumoxid-reichen sowie $SiO_2$-, $Al_2O_3$- und MgO-armen Beschichtung gegenüber alkaliarmen, borosilikatischen Gläsern wie sie heute bei der Beschichtung von Leiterplatten aus Stahl eingesetzt werden, zeigt das beiliegende Diagramm, auf dem die Abhängigkeit des spez. Durchgangswiderstands von der Temperatur wiedergegeben ist.

Kurve 1 gibt die Werte für ein Substrat wieder, das mit erfindungsgemässen Material, bestehend aus 47,0% $B_2O_3$, 32,4% CaO, 11,6% $SiO_2$, 7,3% $Al_2O_3$ und 1,7% MgO, beschichtet wurde.

Kurve 2 wurde an einer alkaliarmen borosilikatischen Beschichtung, bestehend aus 14,0% $B_2O_3$, 26,0% BaO, 39,8% $SiO_2$, 3,4% $Al_2O_3$, 3,0% $ZrO_2$, 3,0% NiO, 1,0% CoO, 4,6% $CaF_2$ und 5,2% $Li_2O$, gemessen.

Derart beschichtete Stahlsubstrate dienen z.B. als Träger für Heizelemente, auf diese werden metallische Heizelemente aufgebracht oder werden mit Widerstandsbahnen z.B. Pastenform bedruckt, die bei Stromdurchgang Wärme entwickeln. Sie finden Einsatz für Wärmeplatten, Warmwasserbereiter oder als Flächenheizelemente zur Raumheizung. In diesen Fällen ist es erforderlich, dass auch bei höheren Temperaturen die isolierenden Eigenschaften der erfindungsgemässen Beschichtung weitgehend erhalten bleibt.

Diese Heizelemente können zur Erzielung einer ästhetischen Wirkung mit farbigen oder dekorativen Emailüberzügen in einer zweiten Schicht in üblicher Weise beschichtet werden.

Eine weitere Anwendung der erfindungsgemäss beschichteten Metallsubstrate ist das Aufbringen von elektrischen Leiterbahnen anstelle der bislang üblichen Verdrahtung mit elektrischen Leitungen, z.B. bei Haus- und Küchengeräten, für elektrische Schalt- und Regelvorgänge.

Der Gegenstand der vorliegenden Erfindung soll nun anhand des folgenden Beispiels noch näher erläutert werden (%-Angaben sind Gew.-%).

Eine Mischung aus 250,2 g Borsäure, 176,7 g Calciumcarbonat, 12,0 g Magnesiumcarbonat, 5,1 g Quarz und 57,9 g Ton der Zusammensetzung $SiO_2$ (48%) und $Al_2O_3$ (38%) wurde in einem mit bei 1500°C gesintertem Quarz ausgekleideten und bereits durch mehrere Schmelzen verdichteten Schamotte-Tiegel im elektrobeheizten Ofen bei 1200°C zwischen 20 und 30 min. geschmolzen. Der auf diese Weise erhaltene klare Schmelzfluss wurde zwischen Stahlwalzen abgeschreckt. Anschliessend wurden die so erhaltenen Flakes in einer Porzellankugelmühle unter Zusatz von 0,04% Methyl-Wasserstoff-Silikonöl so lange vermahlen, das 80% des entstandenen Pulvers eine Teilchengrösse von < 40 μm aufweist. Auf diese Weise wird ein freifliessendes Pulver mit einem Oberflächenwiderstand von $10^{16}$ Ohm erhalten.

Dieses Pulver wird nach einem Verfahren wie es Gegenstand der DE-PS 2 015 072 ist, mit Hilfe einer Pistole, wie sie für die elektrostatische Pulverbeschichtung verwendet wird, unter anlegen einer Spannung von 70 000 Volt an die Koronaelektrode unter Zuhilfenahme von Förderluft auf entfettetes, gebeiztes und vernickeltes, 1 mm dickes Stahlblech aufgebracht. Der Pulverauftrag wurde mit 5,5 g/dm² so gewählt, dass auf dem Stahlblech nach 4-minütigem Einbrennen bei 800°C eine glatte Beschichtung von ca. 200 μm Dicke entsteht.

Das erfindungsgemässe Beschichtungsmaterial kann bereits aus einer einfachen Mischung zweier Mineralien wie Colemanit und Ton erschmolzen werden. Wird Colemanit der Zusammensetzung $B_2O_3$ 42%, CaO 29%, $SiO_2$ 2%, MgO 1,5%, $H_2O$ 25,5% und Ton, der 48% $SiO_2$ und 38% $Al_2O_3$ enthält, verwendet, so ergeben 335,7 g Colemanit und 57,9% g Ton ein Material, das dem im obigen Beispiel angeführten äquivalent ist.

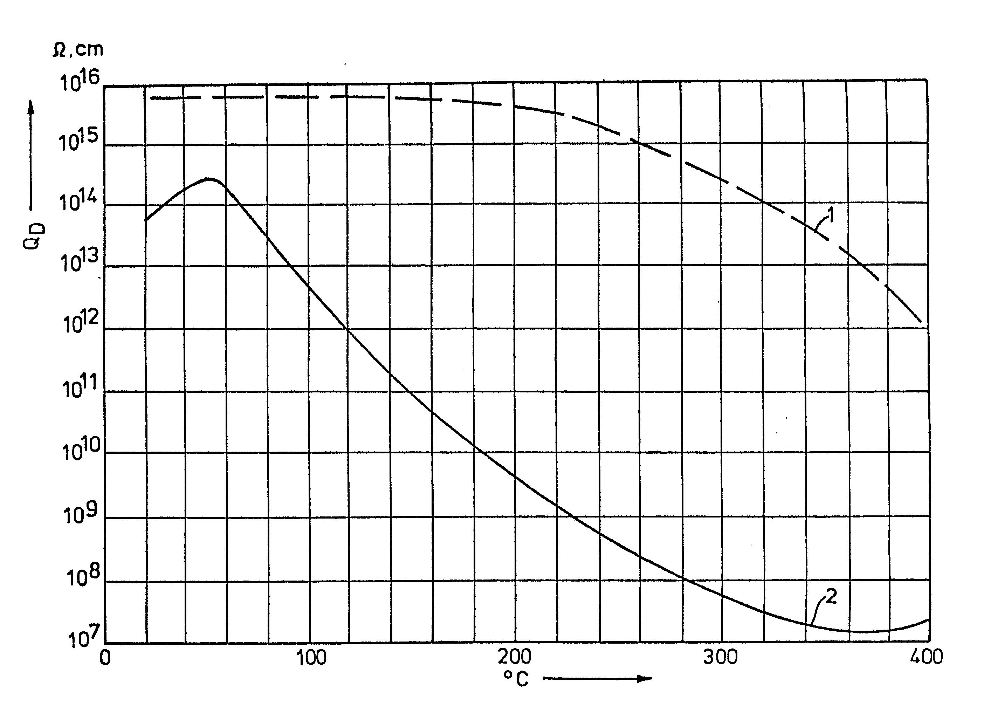

## Patentansprüche

1. Mit elektrisch isolierenden Schichten mit geringer Temperaturabhängigkeit des elektrischen Widerstandes versehene Metallsubstrate, dadurch gekennzeichnet, dass die isolierende Schicht im wesentlichen aus einem aufgeschmolzenen Material besteht, das 43-47 Gew.-% $B_2O_3$, 29-33 Gew.-% CaO, 10-15 Gew.-% $SiO_2$, 7-10 Gew.-% $Al_2O_3$ und 1-2 Gew.-% MgO enthält.

2. Metallsubstrate gemäss Anspruch 1, dadurch gekennzeichnet, dass die aufgeschmolzene Beschichtung aus einem Material besteht, das aus Colemanit- und Ton-Mineralien erhalten wurde.

3. Verfahren zur Herstellung von beschichteten Metallsubstraten gemäss einem der Ansprüche 1 oder 2, dadurch gekennzeichnet, dass man das Beschichtungsmaterial pulverelektrostatisch auf das Substrat aufbringt.

4. Verwendung der Substrate gemäss einem der Ansprüche 1 oder 2 als Basismaterial für elektrische Leiterplatten, gedruckte Schaltungen oder Heizelemente.

## Revendications

1. Substrats métalliques munis de couches électriquement isolantes à faibles variations de la résistance électrique en fonction de la température, caractérisés en ce que la couche isolante consiste essentiellement en un matériau fondu qui contient 43-47% en poids de $B_2O_3$, 29-33% en poids de CaO, 10-15% en poids de $SiO_2$, 7-10% en poids de $Al_2O_3$ et 1-2% en poids de MgO.

2. Substrats métalliques selon la revendication 1, caractérisés en ce que le revêtement fondu consiste en un matériau qui a été obtenu à partir de colémanite et d'argile.

3. Procédé pour la fabrication de substrats métalliques revêtus selon l'une des revendications 1 ou 2, caractérisé en ce que l'on applique le matériau de revêtement sur le substrat par dépôt électrostatique de poudre.

4. Utilisation des substrats selon l'une des revendications 1 ou 2 comme matériau de support pour plaquettes conductrices électriques, circuits imprimés ou éléments chauffants.

## Claims

1. Metal substrates provided with electrically insulating layers having a low temperature dependence of the electrical resistance, characterised in that the insulating layer consists essentially of a melted-on material which contains 43-47% by weight of $B_2O_3$, 29-33% by weight of CaO, 10-15% by weight of $SiO_2$, 7-10% by weight of $Al_2O_3$ and 1-2% by weight of MgO.

2. Metal substrates according to Claim 1, characterised in that the melted-on coating consists of a material obtained from colemanite and clay minerals.

3. Process for the production of coated metal substrates according to one of Claims 1 or 2, characterised in that the coating material is applied to the substrate by electrostatic powder deposition.

4. Use of the substrates according to one of Claims 1 or 2 as a base material for electric printed circuit boards, printed circuits or heating elements.